## Europäisches Patentamt
## European Patent Office
## Office européen des brevets

(11) Veröffentlichungsnummer : **0 124 718**
**B1**

(12) **EUROPÄISCHE PATENTSCHRIFT**

(45) Veröffentlichungstag der Patentschrift :
16.06.87

(51) Int. Cl.⁴ : **H 04 N 7/04**, G 06 F 3/023

(21) Anmeldenummer : **84102572.9**

(22) Anmeldetag : **09.03.84**

(54) **Eingabetastatur für Btx-Terminals und Editiergeräte.**

(30) Priorität : **12.03.83 DE 3308929**

(43) Veröffentlichungstag der Anmeldung :
**14.11.84 Patentblatt 84/46**

(45) Bekanntmachung des Hinweises auf die Patenterteilung : **16.06.87 Patentblatt 87/25**

(84) Benannte Vertragsstaaten :
**AT CH FR GB IT LI NL SE**

(56) Entgegenhaltungen :
**US-A- 4 403 303**
**S. VICKERS "Sinclair ZX spectrum basic program-**
**ming", 1st edition 1982, SINCLAIR RESEARCH LTD.,**
**Cambridge (GB) Seiten 91-93, 112-113**
**S. VICKERS "Sinclair ZX spectrum basic program-**
**ming"**
**Patent Abstracts of Japan vol. 6, no. 62, 21. April 1982**

(73) Patentinhaber : **Deutsche Thomson-Brandt GmbH**
**Hermann-Schwer-Strasse 3 Postfach 2060**
**D-7730 Villingen-Schwenningen (DE)**

(72) Erfinder : **Gleim, Günter**
**Terra Wohnpark 8**
**D-7730 VS-Marbach (DE)**
Erfinder : **Bockwinkel, Norbert**
**Luisenstrasse 13**
**D-7737 Bad Dürheim (DE)**

Anmerkung : Innerhalb von neun Monaten nach der Bekanntmachung des Hinweises auf die Erteilung des
europäischen Patents im Europäischen Patentblatt kann jedermann beim Europäischen Patentamt gegen das erteilte
europäische Patent Einspruch einlegen. Der Einspruch ist schriftlich einzureichen und zu begründen. Er gilt erst als
eingelegt, wenn die Einspruchsgebühr entrichtet worden ist (Art. 99(1) Europäisches Patentübereinkommen).

## Beschreibung

Die vorliegende Erfindung betrifft eine Tastenanordnung mit den im Oberbegriff des Hauptanspruchs angeführten Merkmalen.

Derartige bereits alphanumerisch ausgebildete Tastenanordnungen sind bei Eingabetastaturen für Bildschirmtext-Terminals und Editiergeräte bekannt.

Bei solchen Tastaturen ist es wie bei den Tastaturen von Schreibmaschinen sowie bei Tastenfeldcodiersystemen z. B. nach der in der DE-AS 28 32 673 beschriebenen Art bekannt, eine Taste zur Eingabe von zwei verschiedenen Zeichen zu verwenden, wobei die Auswahl eines dieser Zeichen mittels einer gesonderten Umschalt- oder Vorwahltaste erfolgt. In dieser Weise erfolgt bei Schreibmaschinen die Umschaltung von Klein- auf Großschreibung oder die Auswahl unterschiedlicher Satzzeichen.

Zur Erstellung von Grafiken und Symbolen können neuerdings sogenannte « Smooth-Graphic »-Zeichen über die Eingabetastatur von Bildschirmtextterminals eingegeben werden. Hierfür stehen dem Benutzer 56 verschiedene Smooth-Graphic-Zeichen zur Verfügung. Zur Eingabe dieser Zeichen muß die alphanumerische Tastatur des Terminals bzw. Editiergerätes um 56 weitere Tasten erweitert werden, wodurch die Übersichtlichkeit und damit die Benutzerfreundlichkeit solcher Geräte erheblich verschlechtert würde.

Diese Tastaturerweiterung wird bislang durch folgende Maßnahmen vermieden.

1. Der Benutzer entnimmt aus einer Tabelle den zur Erzeugung des Zeichens erforderlichen Code und gibt diesen manuell ein.

Diese Verfahrensweise ist aufwendig und zeitraubend, da einerseits Tabellen zur Verfügung stehen müssen und andererseits die Codeeingabe nur relativ langsam erfolgen kann.

2. Den 56 Tasten der alphanumerischen Tastatur wird jeweils ein Smooth-Graphic-Zeichen als zusätzliche Belegung zugeordnet, wobei die Aktivierung der belegten Taste durch eine zusätzliche Umschalt- oder Vorwahltaste erfolgt.

Diese Maßnahme ist zwar praktikabler als die unter Ziffer 1. erläuterte. Sie erfordert aber eine Tastatur mit wenigstens 56 Tasten. Da die vorhandenen alphanumerischen Tastaturen in der Regel auch schon zwei oder gar dreifach belegt sind, führt jedoch eine weitere Belegung durch die Smooth-Graphic-Zeichen zu einer Verschlechterung der Übersichtlichkeit und dabei der Bedienungsfreundlichkeit. So müssen die Smooth-Graphic-Zeichen neben den alphanumerischen Zeichen entweder direkt auf den Tasten abgebildet sein oder es muß zur Eingabe der Smooth-Graphic-Zeichen eine Tastenschablone verwendet werden.

Darüber hinaus lassen jedoch die meisten Tastaturen schon aus rein mechanischen Gründen diese Lösung nicht zu.

Aus der Veröffentlichung « Sinclair ZX spectrum basic programming » Ist Edition 1982, Seiten 91-93, 112-113 ist schließlich ein Zuordnungsschema für die Eingabe von grafischen Zeichen und deren Wiedergabe auf einem Bildschirm bekannt, nach welchem eine Anzahl von n-grafischen Zeichen vorgesehen ist, welche aus n/2 zueinander paarweise invertierten Zeichen bestehen, wobei mit einer Auswahltaste zwischen den komplementären Zeichen funktionsmäßig umgeschaltet werden kann.

Bei Verwendung dieses bekannten Schemas läßt sich die Anzahl der für 56 Smooth-Grafic-Zeichen notwendigen Tasten auch nur auf 29 Tasten reduzieren. Dies ist eine Anzahl, die für ein übliches Bildschirmgerät mit einer Tastatur, die bereits mehr als hundert teilweise doppelt belegte Tasten aufweist, noch zu groß ist.

So liegt der Erfindung die Aufgabe zugrunde, die Tastenanordnung der im Oberbegriff des Hauptanspruchs genannten Art so abzuwandeln, daß alle 56 grafische Zeichen mit möglichst wenigen Tasten ohne Verwendung von Tabellen und Tastenschablonen sowie ohne weitere Belegung der vorhandenen alphanumerischen Tastatur eingegeben werden können.

Gelöst wird diese Aufgabe mit den im Kennzeichen des Hauptanspruchs angegebenen Merkmalen.

Durch Verwendung der mit der Erfindung vorgeschlagenen vier Wahltasten läßt sich die Anzahl der zur Eingabe von 56 Smooth-Graphic-Zeichen erforderlichen Eingabetasten auf 14 reduzieren, so daß gegenüber bisher 56 Einzeltasten nur noch 18 einfach zu betätigende Eingabe- und Wahltasten notwendig sind, welche ohne Verschlechterung der Übersichtlichkeit in eine alphanumerische Tastatur integriert werden können.

Weitere Merkmale und Möglichkeiten zur Ausgestaltung der Erfindung sind Gegenstand der Unteransprüche sowie anhand von zeichnerisch veranschaulichten Ausführungsbeispielen im einzelnen nachstehend erläutert.

In den Zeichnungen zeigen

Figur 1 schematische Aufsicht auf 28 Tasten zur Erzeugung aller grafischer Zeichen in ihrer Grundform und mit ihren Spiegelungen sowie das diesem Zeichen entsprechende digitale Codierungsschema,

Figur 2 schematische Aufsicht auf vier zusätzliche erfindungsgemäß vorgeschlagene Tasten, die jeweils der Vorwahl und dem Absenden dienen,

Figur 3a und 3b schematische Aufsicht von drei zusätzlichen erfindungsgemäß vorgeschlagenen Tasten, bei welchen je zwei zu einer Rasttaste zusammengefaßt sind und zwei Tasten der weiteren Vorwahl und dem Absenden dienen.

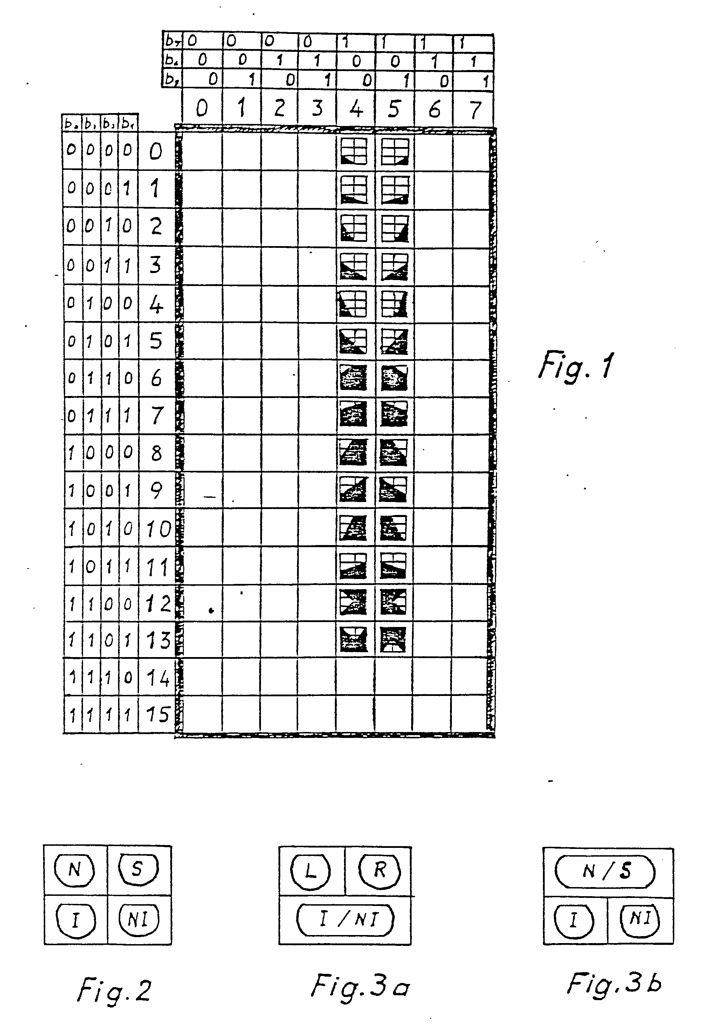

In den Spalten 4 und 5 des Schemas gemäß Figur 1 sind 28 der vereinbarten Smooth-Graphic-Zeichen dargestellt. In den Reihen 0 bis 12 sind die Zeichen wiedergegeben, bei welchen die in Spalte 5 befindlichen Zeichen durch Spiegelung der in Spalte 4 befindlichen Zeichen an der Vertikalen entstehen. Die in Reihe 13 angegebenen Zeichen entstehen dagegen durch Spiegelung an der mittig verlaufenden Horizontalen. Die restlichen nicht dargestellten 28 Zeichen, die zu diesen Zeichen komplementären Zeichen, entstehen durch Invertierung, also dadurch, daß innerhalb der Zeichen helle und dunkle Flächen gegeneinander vertauscht werden.

Bei der erfindungsgemäß ausgebildeten Tastatur sind nur noch 14 dieser 28 in Figur 1 dargestellten Tasten und zusätzlich Wahltasten in den Anordnungen gemäß Figur 2, 3a bzw. 3b vorgesehen.

Bei der Tastenanordnung gemäß Figur 2 dienen die mit N und S bezeichneten Tasten der oberen Reihe der Vorwahl von Zeichen in Normallage (N), also der in Spalte 4 des Schemas gemäß Figur 1 dargestellten Zeichen, und der spiegelbildlichen Zeichen (S), also der in Spalte 5 des Schemas gemäß Figur 1 dargestellten Zeichen.

Mit den in der zweiten Reihe der Tastenanordnung gemäß Figur 2 vorgesehenen und den Buchstaben I und NI bezeichneten Tasten wird bestimmt, ob die mit den Einzeltasten gemäß Figur 1 und den Vorwahltasten N und S gemäß Figur 2 bestimmten Zeichen in invertierter Form, nämlich durch die Taste I, bzw. in nicht invertierter Form, nämlich durch die Taste NI, wiedergegeben werden. Wie schon oben erwähnt, versteht man unter den invertierten Zeichen die komplementäre Darstellung zu den nicht invertierten Zeichen, bei welchen helle gegen dunkle Flächen innerhalb des Zeichens vertauscht sind.

Bei vier einzelnen Vorwahltasten gemäß Figur 2 können diese so geschaltet sein, daß jede dieser vier Tasten zusätzlich die Auslöse- oder Sendefunktion erfüllt, so daß Vorwahl und Absenden stets bei Betätigen der letzten Taste erfolgt.

Bei der abgewandelten Anordnung der Vorwahltasten, wie sie in Figur 3a dargestellt ist, ist anstelle der beiden einzelnen Tasten I und NI eine einzige mit I/NI bezeichnete Rasttaste mit zwei Raststellungen vorgesehen. In einer der beiden Raststellungen wird eine invertierte und in der anderen eine nicht invertierte Zeichenwiedergabe vorgewählt. Die beiden in der ersten Reihe gemäß Figur 3a befindlichen und mit dem Buchstaben L bzw. R bezeichneten Tasten entsprechen den Einzeltasten N und S in Figur 2 und dienen auch hier der Auswahl der in Figur 1 schematisch dargestellten Grundzeichen. Mit der Taste L werden die in Spalte 4, also links, dargestellten Zeichen und mit der Taste R werden die in Spalte 5, also rechts, dargestellten Zeichen ausgewählt. Hierbei ist die Schaltung derart, daß die Vorwahltasten L und R gleichzeitig Ausgabe- oder Sendefunktion erfüllen.

Eine weitere Abwandlung der Tastenanordnung ist mit Figur 3b veranschaulicht. Bei dieser Anordnung sind die Wahltasten zur Vorwahl der Zeichen in normaler Darstellung und spiegelbildlicher Darstellung zu einer Rasttaste N/S zusammengefaßt, in deren einer Raststellung die normale Wiedergabe und in der anderen Raststellung die spiegelbildliche Wiedergabe ausgewählt wird. Die in der zweiten Reihe der Tastenanordnung gemäß Figur 3b vorgesehenen mit I und NI bezeichneten Vorwahltasten entsprechen in ihrer Funktion den gleich bezeichneten Tasten gemäß Figur 2, wobei sie neben der Vorwahlfunktion jeweils gleichzeitig Ausgabe- bzw. Sendefunktion haben.

Wie erläutert, können nach dem erfindungsgemäßen Vorschlag mittels N/4 Tasten für die Grundzeichenauswahl und vier zusätzlichen Vorwahltasten n grafische Zeichen des Smooth-Graphic-Zeichensystemes reproduziert werden, wobei bei Verwendung von Rasttasten mit doppelter Wahlfunktion die Zahl der Wahltasten auf drei reduziert werden kann.

Einzeltasten zur Auswahl der Smooth-Graphic-Zeichen werden zweckmäßigerweise entweder mit den in Spalte 4 des Schemas Figur 1 oder mit den in Spalte 5 des Schemas gemäß Figur 1 angegebenen Symbolen in negativer oder positiver, d. h. invertierter oder nicht invertierter Darstellung, gekennzeichnet. Auch können auf einer Taste beide in Zeilen 0 bis 13 und den Spalten 4, 5 nebeneinander wiedergegebenen Zeichensymbole invertiert oder nicht invertiert angebracht sein.

**Patentansprüche**

1. Tastenanordnung für die Eingabe von Zeichen und deren Wiedergabe auf einem Bildschirm eines Btx-Terminals bzw. Editiergerätes, mit einer Anzahl von Tasten zur Eingabe von mindestens jeweils zwei Zeichen und einem Umschalter zur Auswahl eines dieser beiden Zeichen, dadurch gekennzeichnet,

daß zur Verbindung der grafische Zeichen erzeugenden Eingabetasten mit dem Signal-Ausgang der Tastatur vier Wahltasten vorgesehen sind, mit welchen bei deren Betätigung zusammen mit den Eingabetasten jeweils das grafische Zeichen, das zu diesem spiegelbildliche Zeichen und die jeweiligen komplementären Zeichen auswählbar sind.

2. Tastenanordnung nach Anspruch 1, dadurch gekennzeichnet, daß die Wahltasten (N, S) zur Vorwahl der normalen und der spiegelbildlichen grafischen Zeichen sowie die Wahltasten (I, NI) zur Vorwahl der invertierten (komplementären) bzw. nicht invertierten Zeichen als einzeln zu betätigende Drucktasten ausgebildet sind (Figur 2).

3. Tastenanordnung nach Anspruch 1, dadurch gekennzeichnet, daß zur Vorwahl von Invertierung bzw. Nichtinvertierung eine einzige, in zwei Raststellungen arretierbare Rasttaste (I/NI) und zur Vorwahl der normalen bzw. spiegelbildlichen grafischen Zeichen zwei getrennte, dem Senden oder Auslösen dienende Drucktasten (L, R) vorgesehen sind (Figur 3a) .

4. Tastenanordnung nach Anspruch 1, dadurch gekennzeichnet, daß zur Vorwahl von normalen und deren spiegelbildlichen grafischen Zeichen eine einzige in zwei Raststellungen arretierbare Rasttaste (N/S) und zur Vorwahl von Invertierung bzw. Nichtinvertierung zwei getrennte, dem Senden oder Auslösen dienende Drucktasten (I, NI) vorgesehen sind (Figur 3b).

## Claims

1. A key arrangement for the input of characters and their reproduction on a display screen of a videotext terminal or editing device, with a number of keys for the input of at least two characters at a time and a change-over switch for the selection of one of these two characters, characterised in that in order to connect the input keys producing graphic characters to the signal output of the keyboard, four selection keys are provided with which, when they are actuated together with the input keys, the graphic character, the character in mirror-image to this and the complementary characters to each of these can each be selected.

2. A key arrangement as claimed in Claim 1, characterised in that the selection keys (N, S) for the preselection of the normal and the mirror-image graphic characters, as well as the selection keys (I, NI) for the preselection of the inverted (complementary) and non-inverted characters are constructed in the form of push buttons to be actuated individually (Figure 2).

3. A key arrangement as claimed in Claim 1, characterised in that a single locking key (I/NI), which can be locked in two lock-in positions, is provided for the preselection of inverting or non-inverting and two separate push buttons (L, R), serving for the transmission or actuation, are provided for the preselection of the normal or mirror-image graphic characters (Figure 3a).

4. A key arrangement as claimed in Claim 1, characterised in that a single locking key (N/S), which can be locked in two lock-in positions, is provided for the preselection of normal and their mirror-image graphic characters and two separate push buttons (I, NI), serving for the transmission or actuation, are provided for the preselection of inverting or non-inverting (Figure 3b).

## Revendications

1. Dispositif à touches pour l'introduction de signes et la reproduction sur un écran d'un terminal de vidéotexte ou d'un appareil d'édition, comportant un nombre de touches servant à l'introduction d'au moins respectivement deux signes et d'un commutateur pour la sélection de l'un de ces deux caractères, caractérisé par le fait que pour la liaison des touches d'introduction, produisant des signes graphiques, à la sortie des signaux du clavier il est prévu quatre touches de sélection, à l'aide desquelles on peut sélectionner, lors de leur actionnement, en association avec les touches d'introduction, respectivement le signe graphique, le signe symétrique de ce signe et les signes respectivement complémentaires.

2. Dispositif à touches suivant la revendication 1, caractérisé par le fait que les touches de sélection (N, S) servant à la présélection des signes normaux et des signes graphiques symétriques ainsi que les touches de sélection (I, NI) pour la présélection des signes inversés (complémentaires) ou non inversés sont réalisées sous la forme de boutons-poussoirs devant être actionnés individuellement (figure 2).

3. Dispositif à touches suivant la revendication 1, caractérisé par le fait que pour la présélection d'une inversion ou d'une non-inversion, il est prévu une touche unique à encliquetage (I/NI) pouvant être bloquée dans deux positions d'encliquetage et que, pour la présélection des signes graphiques normaux ou symétriques, il est prévu deux boutons-poussoirs (L, T) séparés servant à l'émission ou au déclenchement (figure 3a).

4. Dispositif à touches suivant la revendication 1, caractérisé par le fait que pour la présélection de signes graphiques normaux ou de signes graphiques symétriques de ces derniers, il est prévu une seule touche à encliquetage (N/S) pouvant être bloquée dans deux positions d'encliquetage et pour la présélection d'une inversion ou d'une non-inversion, il est prévu deux boutons-poussoirs (I, NI) séparés, servant à réaliser l'émission ou le déclenchement (figure 3b).

| | | | | $b_7$ | 0 | 0 | 0 | 0 | 1 | 1 | 1 | 1 |
|---|---|---|---|---|---|---|---|---|---|---|---|---|
| | | | | $b_6$ | 0 | 0 | 1 | 1 | 0 | 0 | 1 | 1 |
| | | | | $b_5$ | 0 | 1 | 0 | 1 | 0 | 1 | 0 | 1 |
| $b_4$ | $b_3$ | $b_2$ | $b_1$ | | 0 | 1 | 2 | 3 | 4 | 5 | 6 | 7 |
| 0 | 0 | 0 | 0 | 0 | | | | | | | | |
| 0 | 0 | 0 | 1 | 1 | | | | | | | | |
| 0 | 0 | 1 | 0 | 2 | | | | | | | | |
| 0 | 0 | 1 | 1 | 3 | | | | | | | | |
| 0 | 1 | 0 | 0 | 4 | | | | | | | | |
| 0 | 1 | 0 | 1 | 5 | | | | | | | | |
| 0 | 1 | 1 | 0 | 6 | | | | | | | | |
| 0 | 1 | 1 | 1 | 7 | | | | | | | | |
| 1 | 0 | 0 | 0 | 8 | | | | | | | | |
| 1 | 0 | 0 | 1 | 9 | | | | | | | | |
| 1 | 0 | 1 | 0 | 10 | | | | | | | | |
| 1 | 0 | 1 | 1 | 11 | | | | | | | | |
| 1 | 1 | 0 | 0 | 12 | | | | | | | | |
| 1 | 1 | 0 | 1 | 13 | | | | | | | | |
| 1 | 1 | 1 | 0 | 14 | | | | | | | | |
| 1 | 1 | 1 | 1 | 15 | | | | | | | | |

Fig. 1

| N | S |
|---|---|
| I | NI |

Fig. 2

| L | R |
|---|---|
| I / NI | |

Fig. 3a

| N / S | |
|---|---|
| I | NI |

Fig. 3b